Europäisches Patentamt

European Patent Office

Office européen des brevets

(19)

(11) EP 0 464 896 B1

(12) **EUROPÄISCHE PATENTSCHRIFT**

(45) Veröffentlichungstag und Bekanntmachung des Hinweises auf die Patenterteilung:
**28.02.1996 Patentblatt 1996/09**

(51) Int Cl.6: **H03H 21/00**

(21) Anmeldenummer: **91201556.7**

(22) Anmeldetag: **19.06.1991**

(54) **Verfahren zur Bildverbesserung und Anordnung zur Durchführung des Verfahrens**

Method of image enhancement and arrangement to implement the method

Procédé d'amélioration d'image et dispositif de mise en oeuvre de ce procédé

(84) Benannte Vertragsstaaten:
**DE FR GB**

(30) Priorität: **29.06.1990 DE 4020643**

(43) Veröffentlichungstag der Anmeldung:
**08.01.1992 Patentblatt 1992/02**

(73) Patentinhaber:
• **Philips Patentverwaltung GmbH**
**D-22335 Hamburg (DE)**
Benannte Vertragsstaaten:
**DE**
• **Philips Electronics N.V.**
**NL-5621 BA Eindhoven (NL)**
Benannte Vertragsstaaten:
**FR GB**

(72) Erfinder: **Heinemann, Hartmut**
**W-2070 Ahrensburg (DE)**

(74) Vertreter: **Hartmann, Heinrich, Dipl.-Ing.**
**D-22335 Hamburg (DE)**

(56) Entgegenhaltungen:
**DE-A- 3 538 735**

• **IEEE PACIFIC RIM CONF. ON COMMUNICATIONS, COMP., AND SIGNAL PROCESSING. VICTORIA (CA);JUNE 4-5 1987: J.U. QUISTGAARD et al "AN ADAPTIVE WINDOW MEDIAN FILTER" P. 440-443.**
• **IEEE TRANSACTIONS ON ACOUSTICS,SPEECH AND SIGNAL PROCESSING. vol. 32, no. 3, June 1984, NEW YORK US pages 571-576; C.A. POMALA-RAEZ et al: 'AN ADAPTIVE NONLINEAR EDGE-PRESERVING FILTER**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Bildverbesserung für ein zweidimensionales, mit wenigstens einem Sensor zeilenweise abgetastetes Bild, das als Folge digitaler Signalwerte in einem Bildspeicher gespeichert ist, sowie eine Anordnung zur Durchführung dieses Verfahrens. Bei der zeilenweisen Abtastung eines Bildes mit einem Sensor, beispielsweise bei der Abtastung einer durch eine Röntgenaufnahme mehr oder weniger entladenen Oberfläche eines Photoleiters, können zeilenförmige Artefakte mit parallel zur Zeilenrichtung verlaufenden Streifen auftreten. Diese Artefakte werden dadurch verursacht, daß die Sensoren und die nachgeschaltete Elektronik Drifteinflüssen ausgesetzt sind.

Aufgabe der vorliegenden Erfindung ist es, diese Artefakte zu beseitigen. Diese Aufgabe wird erfindungsgemäß dadurch gelöst, daß die gespeicherten Signalwerte in solcher Reihenfolge aus dem Speicher ausgelesen werden, daß die Signalwerte von senkrecht zur Zeilenrichtung benachbarten Bildpunkten aufeinanderfolgen, und daß die so gebildete Folge digitaler Signalwerte einer Tiefpaßfilterung unterzogen wird,

- bei der ein gefilterter Signalwert aus einem Kernel von Signalwerten abgeleitet wird und eine Folge gefilterter Signalwerte durch Verschiebung des Kernels relativ zum Signal um jeweils eine Stützstelle gewonnen wird,
- bei der wenigstens einer dem jeweiligen Kernel benachbarten, zuvor noch nicht im Kernel enthaltenen Signalwerte ($x_{i+n+2}$) mit einem aus dem Kernel abgeleiteten Wert ($y_i$) verglichen wird
- und bei der die Kernelgröße (L) bei kleinen Abweichungen in Stufen bis auf einen Maximalwert vergrößert und bei großen Abweichungen in Stufen bis auf einen Minimalwert verringert wird.

Das erfindungsgemäße Verfahren beseitigt die zur Zeilenrichtung parallelen Störkomponenten in dem gespeicherten Bild wirksam, während die eigentliche Bildinformation bei geeigneter Wahl der Filterparameter durch die Tiefpaßfilterung nicht beeinflußt wird.

Bei dem erfindungsgemäßen Verfahren wird die Folge der zu senkrecht zur Zeilenrichtung aufeinanderfolgenden Bildpunkten gehörenden Signalwerte einer Tiefpaßfilterung unterworfen, bei der die Größe des Kernels und damit die Stärke der Signalglättung dem Signalverlauf dynamisch angepaßt wird. Zu dem Zweck wird das Signal "analysiert", indem die Abweichung zwischen einem aus dem Kernel abgeleiteten Wert und einem Signalwert ermittelt wird, der "vor" dem Kernel liegt, d.h. den Kernel noch nicht durchlaufen hat. - Derartige Verfahren zur Tiefpaßfilterung sind aus einem Aufsatz von Quistgaard et al in IEEE PACIFIC RIM CONFERENCE ON COMMUNICATIONS; COMPUTERS AND SIGNAL-PROCESSING, Victoria, Juni 1987, Seiten 440 bis 443 an sich bekannt. Dabei wird der Median der im Kernel enthaltenen Signalwerte mit einem "vor" dem Kernel liegenden Signalwert verglichen.

Bei starken Abweichungen wird angenommen, daß es sich um einen Nutzsignalsprung handelt, der durch die Tiefpaßfilterung möglichst wenig geglättet werden soll. In einem solchen Fall bleibt die "Vorderkante" des Kernels vor dem Signalsprung stehen, und der Kernel wird statt als Ganzes verschoben zu werden, "hinten" um zwei Stellen verkürzt (durch Eliminieren der beiden am längsten im Kernel enthaltenen Signalwerte aus der Kernelsumme). Dadurch wird die Stützstelle bei gleichzeitiger Verkürzung des Kernels weiter verschoben. Bei starken Signalsprüngen wird diese Verkleinerung in Stufen fortgesetzt, bis eine minimale Kernelgröße erreicht ist. Hat die minimale Kernelgröße den Wert 1, dann bedeutet dies, daß keine Glättung mehr statt findet, d.h. das Signal das Filter unverändert passiert. Ist der Minimalwert für die Kernelgröße größer als 1, so wird eine Minimalglättung erzwungen.

Ist andererseits die Abweichung so klein, daß sie durch Rauschsignale verursacht sein könnte, dann wird die Signalglättung verstärkt. Dabei bleibt die Hinterkante des Kernels stehen (der am längsten im Kernel befindliche Signalwert bleibt Teil des Kernels), und der Kernel wird in seinem vorderen Bereich entsprechend vergrößert, bis ein Maximalwert erreicht ist.

Ist ein Maximalwert bzw. ein Minimalwert erreicht, dann erfolgt keine weitere Vergrößerung bzw. Verringerung mehr; der Kernel wird dann in gleicher Weise verschoben wie bei dem bekannten Verfahren.

Der Signalwert, der zur Bestimmung der Abweichung herangezogen wird, kann der Signalwert sein, der - bei konstanter Kernelgröße - als nächster oder übernächster in den Kernel aufgenommen würde oder er könnte aus der gewichteten Summe dieser Werte gebildet werden. Ebenso kann der aus dem Kernel abgeleitete Wert durch einen (z.B. den zuletzt aufgenommenen) Signalwert gebildet werden oder aus einer geeigneten Kombination von darin enthaltenen Signalwerten. Eine bevorzugte Weiterbildung der Erfindung sieht demgegenüber vor, daß die Differenz zwischen dem arithmetischen Mittelwert der jeweils zum Kernel gehörenden Signalwerte und dem zwei Stellen "vor" dem Kernel befindlichen Signalwert gebildet wird, daß die Kernelgröße vergrößert wird, wenn die Differenz einen ersten Schwellenwert unterschreitet und daß die Kernelgröße verringert wird, wenn die Differenz einen zweiten Schwellenwert nicht unterschreitet, der mindestens so groß ist wie der erste Schwellenwert. Der Kernelmittelwert ist dabei gleichzeitig der tiefpaßgefilterte Wert.

Der erste Schwellenwert sollte so bemessen sein, daß die bei Störungen (z.B. Rauschen) des Signals auftretende Differenz ihn in der Regel nicht überschreitet. Der zweite Schwellenwert kann gegebenenfalls die gleiche Größe haben wie der erste. Der Filterprozeß läßt sich mit nur drei Parametern in weiten Grenzen steuern:

a) durch den Minimalwert der Kernelgröße; er legt die Mindestglättung fest. Wird dieser Wert auf "1" gesetzt, findet keine Mindestglättung statt, sondern Signalkanten passieren das Filter unverfälscht. Dieser Parameter sollte in Abhängigkeit der Signalkanten festgesetzt werden.

b) durch den Maximalwert der Kernelgröße; er legt die Maximalglättung fest. Dieser Parameter sollte so gewählt werden, daß das Rauschen in Gebieten ohne Signalkanten hinreichend gut gedämpft wird. Er sollte allerdings deutlich kleiner sein als die Gesamtzahl der Stützstellen.

c) durch die Schwelle(n); dieser Parameter sollte so gewählt werden, daß Störungen im Signal (Rauschen etc) ihn in der Regel nicht überschreiten, echte Sprünge im Nutzsignal im allgemeinen aber größer sind als er.

Eine Anordnung zur Durchführung des erfindungsgemäßen Verfahrens ist gekennzeichnet durch eine Signalquelle zur Erzeugung eines digitalen Signals, durch einen Speicher mit zumindest dem Maximalwert der Kernelgröße entsprechender Speicherkapazität und durch einen Signalprozessor, der die im Speicher befindlichen Signalwerte zur Erzeugung eines gefilterten Signalwertes heranzieht und der so ausgebildet ist, daß die Kernelgröße bei kleinen Änderungen innerhalb des Signals in Stufen bis zu einem Maximalwert vergrößert und bei großen Änderungen in Stufen bis auf einen Minimalwert verringert wird.

Die Erfindung wird nachstehend anhand der Zeichnung näher erläutert. Es zeigen:

Figur 1 ein durch eine Folge digitaler Signalwerte gebildetes Signal,

Figur 2 eine Anordnung zur Tiefpaßfilterung eines solchen Signals,

Figur 3 ein Fluß-Diagramm eines Programmteils, nach dem ein Rechner, z.B. der in der Anordnung nach Fig. 2 enthaltene programmierbare Signalprozessor, die Signalwerte verarbeitet.

Figur 4 ein ungefiltertes Signal und das zugehörige nach dem erfindungsgemäßen Verfahren verarbeitete Signal und

Figur 5 die jeweilige Kernelgröße bei der Tiefpaßfilterung.

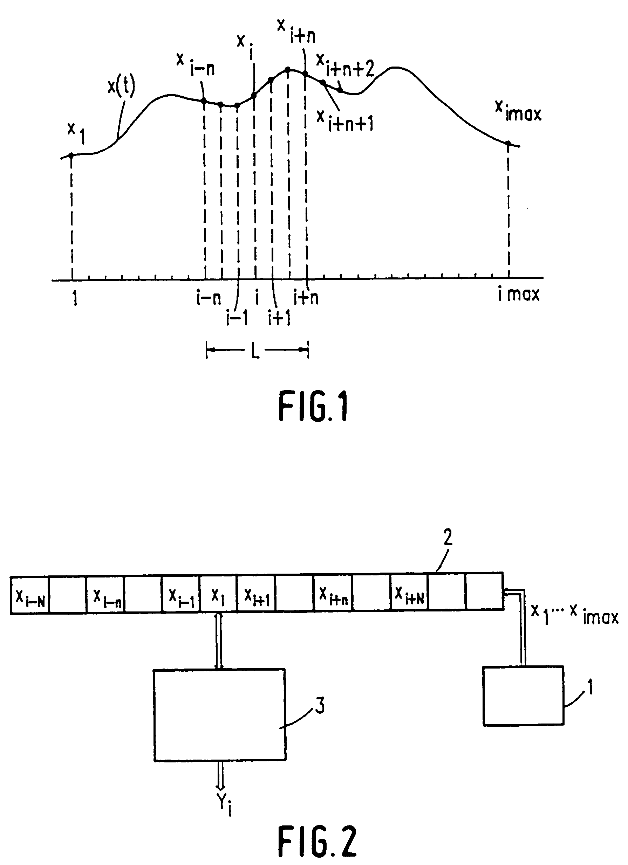

Fig. 1 zeigt ein Signal $x(t)$, das aus einer Folge von Signalwerten $x_1 .. x_{imax}$ besteht, die senkrecht zur Zeilenrichtung aufeinanderfolgenden Bildpunkten eines in einem Bildspeicher gespeicherten Bildes zugeordnet sind. Die Signalwerte $x_{i-n} ... x_{i+n}$ bilden den Kernel für die Berechnung eines tiefpaßgefilterten Wertes $y_i$ an der Stützstelle i. Im einfachsten Fall errechnet sich $y_i$ an der Stützstelle i als arithmetischer Mittelwert der zu dem Kernel gehörenden Signalwerte; jedoch ist es auch möglich, den gefilterten Wert $y_i$ aus der in geeigneter Weise gewichteten Summe der im Kernel enthaltenen Signalwerte zu berechnen. - Die Kernelgröße L errechnet sich aus dem Wert n nach der Formel

$$L = 2n+1$$

Bei einem bekannten Verfahren (P. Haberäcker: "Digitale Bildverarbeitung: Grundlagen und Anwendungen", Carl Hanser Verlag, München Wien) zur Tiefpaßfilterung wird zur Berechnung des gefilterten Wertes $y_{i+1}$ an der Stützstelle i+1 ein Kernel verwendet, der gegenüber dem zuvor beschriebenen Kernel um eine Stützstelle nach rechts verschoben ist. Dabei wird der in dem vorherigen Kernel enthaltene Wert $x_{i-n}$ aus der Kernelsumme eliminiert und der Wert $x_{i+n+1}$ in die Kernelsumme einbezogen. Die Länge des Kernels bleibt hierbei konstant; nur dessen Lage in bezug auf das Signal wird um eine Stützstelle verschoben.

Demgegenüber wird bei der Erfindung die Länge des Kernels vom Signalverlauf abhängig gemacht. Zu diesem Zweck wird die Differenz zwischen dem zwei Stellen "vor" dem Kernel liegenden Signalwert $x_{i+n+2}$ und dem gefilterten Wert $y_i$ an der Stützstelle i gebildet, der z.B. der arithmetische Mittelwert aller Werte im Kernel ist.

Ist diese Differenz geringer als eine als externer Parameter vorgegebene Schwelle S1, dann wird nicht nur der Signalwert $(x_{i+n+1})$ an der nächsten Stützstelle zu dem Kernel hinzugenommen, sondern auch der übernächste Signalwert $(x_{i+n+2})$; der "älteste" Signalwert im Kernel $(x_{i-n})$ bleibt hingegen erhalten. Die Kernelgröße wächst hierbei also bei einem Verschiebungsschritt um zwei Stützstellen, aber höchstens bis sie ihren vorgegebenen Maximalwert erreicht hat.

Ist die Differenz hingegen größer als die bei den üblichen Signal störungen (Rauschen u.dgl.) in der Regel auftretenden Differenzen, dann wird die Kernelgröße verringert, indem einerseits der neu hinzugekommene Signalwert $(x_{i+n+1})$ und der älteste Signalwert $(x_{i-n-1})$ eliminiert werden. Die vordere Stützstelle (i+n) ändert in diesem Fall bei einer Verschiebung des Kernels also ihre Lage nicht, und dies gilt solange, bis die Kernelgröße einen vorgegebenen Minimalwert erreicht hat, bei dem der Kernel z.B. nur noch einen Signalwert umfaßt. Mit diesem kleinen Kernel wird dann der Signalsprung verarbeitet.

In Figur 2 ist schematisch eine Schaltungsanordnung zur Durchführung des erfindungsgemäßen Verfahrens dargestellt. Sie besitzt eine digitale Signalquelle 1, die eine Folge digitaler Signalwerte liefert. Die Signalquelle umfaßt einen Bildspeicher, aus dem die Signalwerte eines Bildes in solcher Reihenfolge ausgelesen werden, daß diese Signalwerte von benachbarten und senkrecht zur Zeilenrichtung versetzten Bildpunkten unmittelbar aufeinander folgen. Die Signalwerte werden fortlaufend in einem Speicher 2 gespeichert, der mindestens zwei Speicherplätze mehr aufweist, als in einem Kernel von maximaler Länge Signalwerte enthalten sind. Bei jedem neuen Signalwert, der in dem Speicher 2 eingelesen wird, werden die schon gespeicherten Signalwerte um einen Speicherplatz (in Fig. 2 nach links) verschoben, wobei der am längsten im Speicher befindliche Wert (im vorliegenden Fall ist das der Wert $x_{i-N}$) verschwindet. Ein Signalprozessor 3, der auf jeden der Speicherplätze im Speicher 2 zugreifen kann, verarbeitet die Signalwerte und liefert die gefilterten Signalwerte $y_i$.

Der Signalprozessor könnte eine auf die Problemstellung zugeschnittene Hardware enthalten. Vorzugsweise ist der Signalprozessor 3 aber programmierbar ausgebildet und umfaßt einen Mikroprozessor oder einen größeren Digitalrechner.

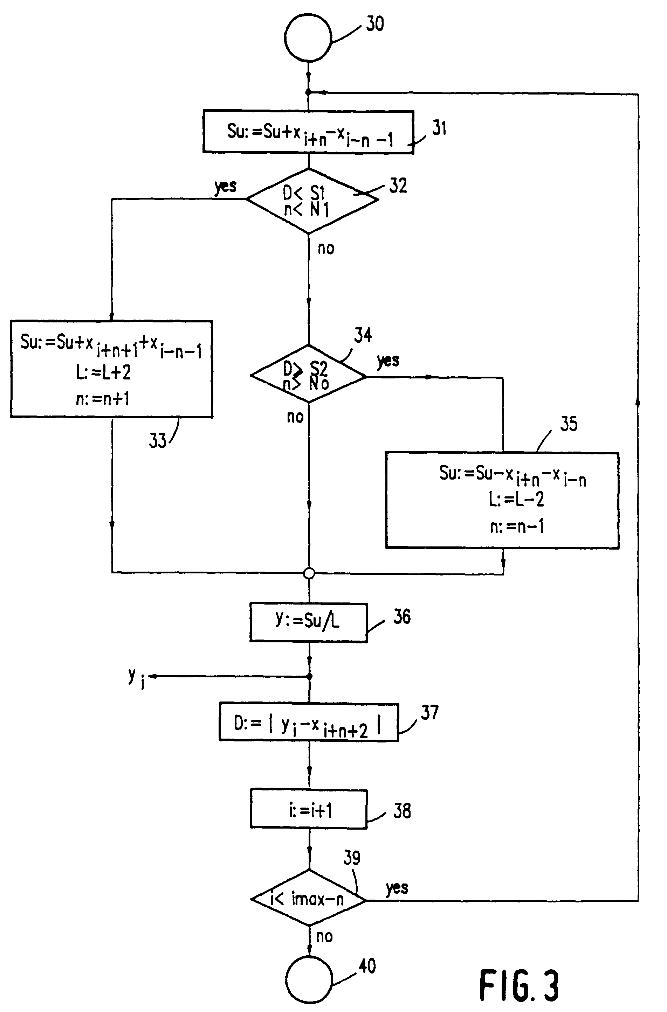

Fig. 3 zeigt einen Teil eines Fluß-Diagramms des von dem Signalprozessor durchgeführten Signalverarbeitungsprogramms. Mit 30 ist dabei ein Programmteil bezeichnet, der die Initialisierung bewirkt und die ersten gefilterten Werte für den Signalanfang liefert. Insoweit kann das Programm den bekannten Verfahren mit konstanter Kernellänge entsprechen. Es sei angenommen, daß für eine Stützstelle i-1 ein gefilterter Signalwert $y_{i-1}$ berechnet worden sei und daß zusätzlich die Größen Su, L, D und i vorgegeben seien. Der Wert Su stellt die Summe der Signalwerte $(x_{i-n-1} .... x_{i+n-1})$ dar, die der Lage des Kernels um die Stützstelle i-1 entsprechen, während L die zu dem gefilterten Wert $y_{i-1}$ gehörige Kernellänge ist.

Danach wird in einem Programmschritt 31 zunächst die Summe verändert, indem der Wert $x_{i+n}$ hinzuaddiert und der Wert $x_{i-n-1}$ subtrahiert wird. Der neu berechnete Summenwert Su entspricht daher der Summe der Signalwerte eines Kernels um den zentralen Wert $x_i$.

Anschließend erfolgt im Programmteil 32 eine zweifache Abfrage mit Verzweigung. Dabei wird geprüft, ob der Wert D kleiner ist als ein erster Schwellenwert S1 und ob die Zahl n kleiner ist als ein Maximalwert N1. Der erste Schwellenwert S1 sollte dem Rausch- bzw. Störpegel angepaßt sein, so daß er in der Regel von der Differenz D nur bei Änderung des Nutzsignals nicht aber allein durch Störungen, Rauschen oder dgl. überschritten werden kann. Der Wert N1 gibt die Maximalgröße des Kernels vor (2N1+1), bis zu der der Kernel vergrößert werden kann. Sie sollte wesentlich weniger Signalwerte umfassen als das zu filternde Signal.

Nur wenn beide Bedingungen erfüllt sind, verzweigt das Programm zu dem Block 33. Darin wird zunächst die (in 31 neu berechnete) Kernelsumme um die beiden Signalwerte beiderseits des - verschobenen - Kernels vergrößert. De facto unterscheidet sich also die im Block 33 gebildete Summe Su von der ursprünglichen Summe Su dadurch, daß die in Fig. 1 mit $x_{i+n+1}$ und $x_{i+n}$ bezeichneten Werte hinzuaddiert worden sind. Dies entspricht der Summe der Signalwerte eines Kernels, dessen Länge L gegenüber der Länge des ursprünglichen Kernels um 2 vergrößert ist und dessen zentraler Wert um eine Stützstelle verschoben worden ist (von i-1 nach i). Demzufolge wird anschließend in dem Programmblock 33 die Länge L um 2 erhöht und der Wert n um 1.

Ist im Block 32 auch nur eine der beiden Bedingungen nicht erfüllt, dann erfolgt eine Verzweigung zu einem Block 34, in dem eine weitere Abfrage erfolgt. Darin wird geprüft, ob die Differenz D nicht kleiner ist als ein zweiter Schwellenwert S2 und ob der Wert n größer ist als ein Minimalwert No, beispielsweise größer als 0. Der zweite Schwellenwert S2 muß größer oder gleich dem ersten Schwellenwert S1 sein. Sind die beiden Schwellenwerte gleich, dann ändert sich die Kernelgröße ständig, so lange n zwischen dem Maximalwert N1 und dem Minimalwert No bleibt; andernfalls gibt es einen Bereich, in dem aufeinanderfolgende Filterwerte auch die gleiche Kernellänge haben können.

Wenn die beiden Bedingungen des Blockes 34 erfüllt sind, erfolgt eine Verzweigung zu einem Block 35. Darin wird zunächst die Kernelsumme neu berechnet, indem der erste und der letzte Signalwert von der im Block 31 neu berechneten Summe Su subtrahiert werden. Dies läuft darauf hinaus, daß von dem in Fig. 1 durch gestrichelte Linien symbolisierten Kernel die beiden äußeren Signalwerte bei der Summenbildung unberücksichtigt bleiben. Dies entspricht der Summe eines Kernels, dessen zentrale Stützstelle bei i+1 liegt und dessen Größe um 2 verringert ist. Demgemäß wird im Block 35 der Wert L um 2 verringert und der Wert n um 1.

Wenn auch nur eine Bedingung des Blockes 34 nicht erfüllt ist oder wenn die Blöcke 33 oder 35 durchlaufen sind, gelangt das Programm zum Block 36, wo der gefilterte Wert $y_i$ berechnet wird. Im einfachsten Fall wird zu diesem Zweck lediglich der Quotient Su/L gebildet (arithmetischer Mittelwert), wobei Su und L ggf. in einem der Blöcke 33 oder 35 gegenüber den vom Block 31 vorgegebenen Wert neu berechnet sein können. Die auf diese Weise gefilterten Signalwerte können in geeigneter Weise ausgegeben werden; sie können aber auch in einen Speicher übernommen werden.

Anschließend wird in einem Block 37 D als Betrag der Differenz zwischen dem gefilterten Wert $y_i$ und dem Signalwert $(x_{i+n+2})$ gebildet. Schließlich wird im Block 38 der Index i um 1 vergrößert und damit der neuen Lage des Kernels angepaßt. Dies kann z.B. dadurch erfolgen, daß alle Signalwerte im Speicher in den jeweils nächsten Speicherplatz geschoben werden.

In einem Block 39 schließlich wird geprüft, ob der Kernel bereits in der Nähe der letzten Stützstelle imax angelangt ist. Ist dies der Fall, dann erfolgt im Programmteil 40 ein Ende des Programms, ggf. unter Ausgabe auf geeignete Weise erzeugter Randwerte.

Ist hingegen die Bedingung des Blocks 39 erfüllt, dann erfolgt ein Rücksprung zum Block 31, wodurch eine Programmschleife gebildet wird, die so oft durchlaufen wird, bis der Kernel in den Endbereich des Signals gelangt. Beim mehrfachen Durchlaufen der Programmschleife kann es vorkommen, daß der Block 33 jedesmal aufgerufen und dementsprechend die Kernelgröße jedesmal um 2 vergrößert wird, bis der Maximalwert N1 erreicht ist. In diesem Fall werden also auch noch der erste und der letzte Signalwert in dem Speicher 2 zur Verarbeitung herangezogen. - Ebenso kann bei starken Signalschwankungen auch der Block 35 mehrfach durchlaufen werden, bis die Minimallänge No erreicht ist.

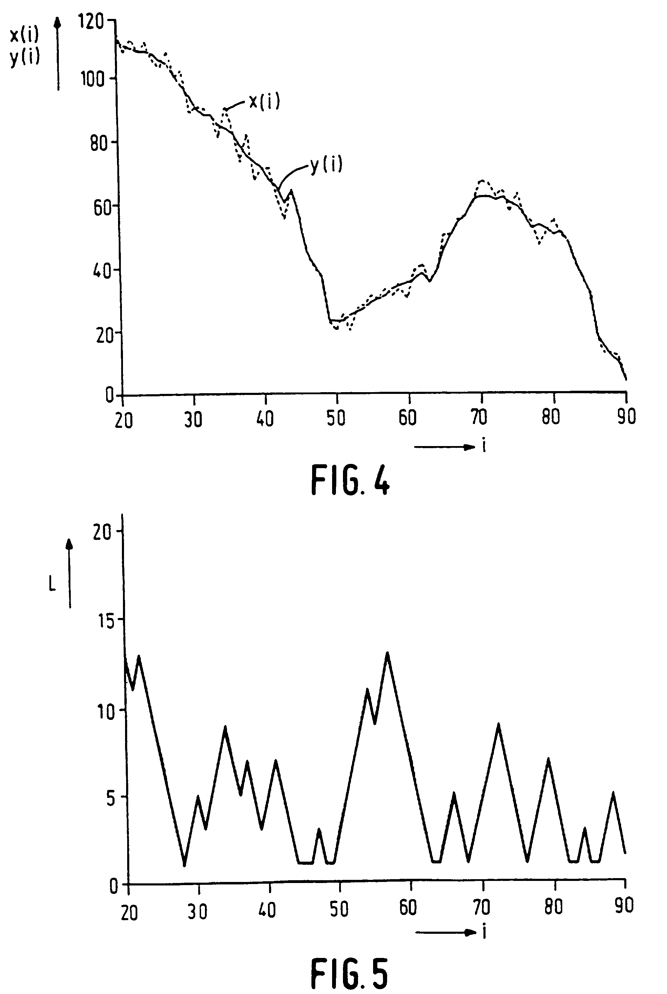

Figur 4 zeigt den Verlauf eines ungefilterten Signals x(i) und eines gefilterten Signals y(i) über einen Ausschnitt von i=20 bis i=90. Dabei waren die Schwellenwerte S1=S2=7 gewählt. Der Wert N1 betrug 10 (was einer maximalen Kernelgröße von 21 entspricht) und der Minimalwert No war 0, entsprechend einer minimalen Kernelgröße 1. Man erkennt, daß sich in einigen Bereichen (mit geringen Signalschwankungen), z.B. zwischen i=20 und i=30 oder zwischen i=55 und i=60 eine starke Signalglättung ergibt, während in anderen Bereichen, z.B. im Bereich zwischen 40 und 50 und im Bereich zwischen 80 und 90 kaum eine Glättung erfolgt, so daß die dort vorhandenen starken Signalsprünge praktisch unverfälscht übertragen werden.

In Figur 5 ist die zur Glättung des Signals x(t) in Fig. 4 jeweils benutzte Kernelgröße L als Funktion der Stützstelle i im selben Bereich wie dort dargestellt. Man erkennt, daß die maximale Kernellänge in den dargestellten Signalausschnitt an keiner Stelle erreicht wird, während die minimale Kernelgröße an mehreren jeweils durch steile und sich über einen größeren Bereich erstreckende Signalflanken gekennzeichneten Stellen den Wert 1 erreicht.

Die gefilterten Signalwerte können wieder in den Bildspeicher zurückgeschrieben werden, wobei lediglich dafür gesorgt werden muß, daß die noch in einem Kernel zur Berechnung der gefilterten Werte benötigten Bildwerte zwischengespeichert werden. Bei Vorhandensein eines Bildspeichers, in dem das gesamte Signal gespeichert ist, ist es wenig sinnvoll, zur Gewinnung eines Kernels für die nächste Stützstelle das Signal innerhalb des Speichers zu verschieben. In diesem Fall ist es zweckmäßiger, lediglich die Adressen der heranzuziehenden Bildwerte um 1 zu verändern. Der Aufwand für die Berechnung der gefilterten Werte $y_i$ wird durch das erfindungsgemäße Verfahren gegenüber dem eingangs bekannten Verfahren mit konstanter Kernellänge nur relativ geringfügig vergrößert, weil lediglich die durch die Blöcke 32 bis 35 und 37 symbolisierten Rechenschritte zusätzlich ausgeführt werden müssen. In der Praxis ergibt sich damit lediglich eine Verlängerung der Rechenzeit von ca. 10 %.

Für die praktische Ausführung mag es u.U. aus Rechenzeitgründen sinnvoll erscheinen, die Rechenschritte anders zusammenzufassen.

Beim Durchlaufen der in Fig. 3 dargestellten Programmschleife wird die Kernelsumme Su unter Umständen zweimal berechnet, nämlich einmal im Block 31 und ggf. ein weiteres Mal in einem der Blöcke 33 oder 35. Diese zweifache Berechnung läßt sich vermeiden, wenn die Summenberechnung Su für den verschobenen Kernel nicht im Block 31 durchgeführt wird, sondern in einem hinter dem Block 34 einzufügenden Block. In diesem Fall müßte die Kernelsumme im Block 33 um die beiden nächsten $x_{i+n+1}$ und $x_{i+n+2}$ Signalwerte erhöht werden, während sie im Block 35 um die beiden Kernelwerte $x_{i-n}$ und $x_{i-n-1}$ verringert werden müßte. Bei einem in dieser Weise modifizierten Programm würde im Block 31 der arithmetische Mittelwert der Signale des unverschobenen Kernels mit dem übernächsten Signalwert ($x_{i+n+2}$) verglichen.

## Patentansprüche

1. Verfahren zur Bildverbesserung für ein zweidimensionales, mit wenigstens einem Sensor zeilenweise abgetastetes Bild, das als Folge digitaler Signalwerte in einem Bildspeicher gespeichert ist,
   dadurch gekennzeichnet, daß die gespeicherten Signalwerte in solcher Reihenfolge aus dem Speicher ausgelesen werden, daß die Signalwerte von senkrecht zur Zeilenrichtung benachbarten Bildpunkten aufeinanderfolgen, und daß die so gebildete Folge digitaler Signalwerte einer Tiefpaßfilterung unterzogen wird,

   - bei der ein gefilterter Signalwert aus einem Kernel von Signalwerten abgeleitet wird und eine Folge gefilterter Signalwerte durch Verschiebung des Kernels relativ zum Signal um jeweils eine Stützstelle gewonnen wird,
   - bei der wenigstens einer dem jeweiligen Kernel benachbarten, zuvor noch nicht im Kernel enthaltenen Signalwerte ($x_{i+n+2}$) mit einem aus dem Kernel abgeleiteten Wert ($y_i$) verglichen wird
   - und bei der die Kernelgröße (L) bei kleinen Abweichungen in Stufen bis auf einen Maximalwert vergrößert und bei großen Abweichungen in Stufen bis auf einen Minimalwert verringert wird.

2. Verfahren nach Anspruch 1,
   dadurch gekennzeichnet, daß die Differenz (D) zwischen dem arithmetischen Mittelwert ($y_i$) der jeweils zum Kernel gehörenden Signalwerte und dem zum Kernel benachbarten Signalwert ($x_{i+n+2}$) gebildet wird, daß die Kernelgröße (L) vergrößert wird, wenn die Differenz (D) einen ersten Schwellenwert (S1) unterschreitet und daß die Kernelgröße verringert wird, wenn die Differenz einen zweiten Schwellenwert (S2) nicht unterschreitet, der mindestens so groß ist wie der erste Schwellenwert.

3. Anordnung zur Durchführung des Verfahrens nach Anspruch 1,
   gekennzeichnet durch einen Speicher (2) mit zumindest dem Maximalwert der Kernelgröße entsprechender Speicherkapazität und durch einen Signalprozessor (3), der die im Speicher (2) befindlichen Signalwerte zur Erzeugung eines gefilterten Signalwertes ($y_i$) heranzieht und der so ausgebildet ist, daß die Kernelgröße bei kleinen Abweichungen eines zuvor noch nicht im Kernel enthaltenen, dem Kernel benachbarten Signalwertes ($x_{i+n+2}$) von einem aus dem Kernel abgeleiteten Wert ($y_i$) die Kernelgröße (L) in Stufen bis zu einem Maximalwert vergrößert und bei großen Abweichungen in Stufen bis auf einen Minimalwert verringert wird, und durch Mittel zum Speichern von Bildpunkten in zeilenweiser Folge, sowie durch Mittel zum Auslesen der gespeicherten Signalwerte zur Tiefpaßfilterung in solcher Reihenfolge, daß die Signalwerte von senkrecht zur Zeilenrichtung benachbarten Bildpunkten aufeinanderfolgen.

## Claims

1. A method of image enhancement of a two-dimensional picture scanned line by line by means of at least one sensor, which picture is stored as a sequence of digital signal values in a picture memory, characterized in that the stored signal values are read from the memory in such a sequence that the signal values of neighbouring pixels which are perpendicular to the line direction succeed each other, and in that the sequence of digital signal values thus formed is subjected to a low-pass filtering

   - in which a filtered signal value is derived from a kernel of signal values, and a sequence of filtered signal values is obtained by shifting the kernel relatively to the signal each time by one sample position,
   - in which at least one of the signal values ($x_{i+n+2}$) proximate to the relevant kernel and previously not comprised in the kernel is compared with a value ($y_i$) derived from the kernel
   - and in which the kernel length (L) is step-wise increased to a maximum value in the case of small differences and is step-wise reduced to a minimum value in the case of large differences.

2. A method as claimed in Claim 1, characterized in that the difference (D) is formed between the arithmetic mean value ($y_i$) of the signal values associated with the kernel and the signal value ($x_{i+n+2}$) proximate to the kernel, in that the kernel length (L) is increased when the difference (D) falls below a first threshold value (S1) and in that the kernel length is reduced when the difference does not fall below a second threshold value (S2) which is at least as large as the first threshold value.

3. An arrangement for performing the method as claimed in Claim 1, characterized by a memory (2) having a memory capacitance which corresponds at least to the maximum value of the kernel length, and a signal processor (3) which utilizes the signal values in the memory (2) for generating a filtered signal value ($y_i$) and is formed in such a way that the kernel length is step-wise increased to a maximum value in the case of small differences between a signal value ($x_{i+n+2}$) proximate to and previously not comprised in the kernel and a value ($y_i$) derived from the kernel and is step-wise reduced to a minimum value in the case of large differences, and means for storing pixels line by line, as well as means for reading the stored signal values for low-pass filtering in such a sequence that the signal values of neighbouring pixels which are perpendicular to the line direction succeed each other.

## Revendications

1. Procédé d'amélioration d'image pour une image bidimensionnelle analysée ligne par ligne à l'aide d'au moins un capteur, qui est stockée dans une mémoire d'image sous la forme d'une séquence de valeurs de signaux numériques, caractérisé en ce que les valeurs de signaux stockés sont extraites par lecture de la mémoire dans un ordre de succession tel que les valeurs de signaux de points d'image voisins perpendiculairement à la direction des lignes se succèdent et que la séquence de valeurs de signaux numériques ainsi formées est soumise à un filtrage passe-bas, dans lequel

   - une valeur de signal filtré est dérivée d'un noyau de valeurs de signaux et une séquence de valeurs de signaux filtrés est obtenue par déplacement du noyau par rapport au signal de chaque fois un noeud;
   - dans lequel au moins une des valeurs de signaux ($x_{i+n+2}$) voisine du noyau en question, et tout d'abord non encore contenue dans le noyau, est comparée à une valeur ($y_i$) dérivée du noyau, et
   - dans lequel la grandeur du noyau (L) est pour de petits écarts augmentée par stades successifs jusqu'à une valeur maximale et pour de grands écarts, est diminuée par stades successifs jusqu'à une valeur minimale.

2. Procédé suivant la revendication 1, caractérisé en ce que la différence (D) entre la moyenne arithmétique ($y_i$) des valeurs de signaux appartenant chaque fois au noyau et de la valeur de signal ($x_{i+n+2}$) voisine du noyau est formée, que la grandeur de noyau (L) est accrue lorsque la différence (D) reste en deçà d'une première valeur de seuil (S1) et que la grandeur de noyau est diminuée lorsque la différence n'est pas en deçà d'une seconde valeur de seuil (S2) qui est au moins égale à la première valeur de seuil.

3. Dispositif pour l'exécution du procédé suivant la revendication I, caractérisé par une mémoire (2) dont la capacité de stockage est au moins égale à la valeur maximale de la grandeur de noyau et par un processeur de signal (3) qui utilise les valeurs de signal se trouvant dans la mémoire (2) pour produire une valeur de signal ($y_i$) filtrée et qui est agencé de manière telle que, dans le cas de faibles écarts entre une valeur de signal ($x_{i+n+2}$) voisine du noyau, mais non encore contenue dans le noyau, et une valeur ($y_i$) dérivée du noyau, la grandeur de noyau (L) soit accrue par stades successifs jusqu'à une valeur maximale et que, dans le cas d'écarts importants, elle soit diminuée par stades successifs jusqu'à une valeur minimale et par des moyens pour stocker des points d'image, ligne par ligne, ainsi que par des moyens pour l'extraction par lecture des valeurs de signal mémorisées en vue d'un filtrage passe-bas dans un ordre de succession tel que les valeurs de signal de points d'image voisins perpendiculairement à la direction des lignes se succèdent.

FIG.1

FIG.2

```
                              ○────30

        ┌──────────────────────┐
        │ Su:=Su+x_{i+n}-x_{i-n-1} ├──31
        └──────────────────────┘
                    │
   yes        ◇ D< S1          ◇────32
  ┌──────────◇ n< N1          ◇
  │           ◇               ◇
  │                │ no
  │                │
┌──────────────┐   │
│ Su:=Su+x_{i+n+1}+x_{i-n-1} │  │
│ L:=L+2       │   │        ◇ D> S2    ◇──34   yes
│ n:=n+1       │   │        ◇ n> No    ◇──────────┐
└──────────────┘   │         ◇        ◇           │
      33           │            │ no              │
                   │            │      ┌──────────────────┐──35
                   │            │      │ Su:=Su-x_{i+n}-x_{i-n} │
                   │            │      │ L:=L-2            │
                   │            │      │ n:=n-1            │
                   │            │      └──────────────────┘
                   │            │                │
                   └────────────○────────────────┘
                                │
                        ┌──────────────┐
                        │ y:=Su/L      ├──36
                        └──────────────┘
                                │
                 y_i ◄──────────│
                                │
                        ┌──────────────────┐
                        │ D:= | y_i-x_{i+n+2} | ├──37
                        └──────────────────┘
                                │
                        ┌──────────────┐
                        │ i:=i+1       ├──38
                        └──────────────┘
                                │
                         ◇ i< imax-n ◇──39   yes
                         ◇          ◇──────────┘
                                │ no
                                ○────40
```

FIG. 3

FIG. 4

FIG.5